# EUROPEAN PATENT APPLICATION

(11) **EP 4 782 918 A1**
(43) Date of publication of application: **29.07.2026**
(21) Application number: 25154212.2
(22) Date of filing: 27.01.2025
(51) Int. Cl.: G03F 7/00

(54) **APPARATUS FOR A LASER-PRODUCED PLASMA RADIATION SOURCE**

(71) Applicant: ASML Netherlands B.V., 5500 AH Veldhoven (NL)
(72) Inventor: KOCKEROLS, Jean, 5500AH Veldhoven (NL); SUBKHANGULOV, Ruslan Rifovich, 5500AH Veldhoven (NL); HARRISON, Kramer, Daniel, 5500AH Veldhoven (NL); UTINA, Andrei, Catalin, 5500AH Veldhoven (NL); CORONEL, Joshua, 5500AH Veldhoven (NL); JURNA, Martin, 5500AH Veldhoven (NL)
(74) Representative: ASML Netherlands B.V.

(57) **Abstract**

An apparatus for a laser-produced plasma radiation source comprises a generally tubular body. A radially inner surface of the generally tubular body is provided with a structure configured such that radiation received by said radially inner surface from a second axial end is at least partially directed back through the second axial end of the generally tubular body. The generally tubular body may comprise inner and outer tubular portions that define a fluid passageway which may be arranged such that an outlet of the fluid passageway directs fluid received at an inlet generally radially outwards from an axis of the generally tubular body. The apparatus may further comprise a collector provided with a concave reflective surface with a central aperture; and the generally tubular body may be disposed in the central aperture of the collector.

## Description

### FIELD

The present invention relates to an apparatus for a laser-produced plasma radiation source. The present invention also relates to a laser-produced plasma radiation source comprising the apparatus. The present invention also relates to an exposure apparatus comprising the laser-produced plasma radiation source. The exposure apparatus may, for example, comprise a lithographic apparatus (also known as a scanner), a metrology apparatus or an inspection apparatus.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography typically uses reflective surfaces instead of a lenses as optics. Mask blanks used in EUV lithography generally have a multilayer structure which functions as a Bragg reflector, the multilayers may comprise alternatingly layers of Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5 nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Fourth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

It may be desirable to provide new apparatus for use in a laser-produced plasma source that at least partially addresses one or more problems associated with existing designs, whether such problems are identified herein or otherwise.

### SUMMARY

According to a first aspect of the present disclosure there is provided an apparatus for a laser-produced plasma radiation source, the apparatus comprising a generally tubular body defining an axis and extending from a first axial end to a second axial end; wherein the generally tubular body comprises an inner tubular portion and an outer tubular portion surrounding the inner tubular portion so as to define a volume therebetween, the volume defining a fluid passageway extending from an inlet at the first axial end to an outlet proximate to the second axial end; wherein the inner tubular portion and the outer tubular portion are arranged such that the outlet of the fluid passageway directs fluid received at the inlet generally radially outwards from the axis; and wherein a radially inner surface of the generally tubular body is provided with a structure configured such that radiation received by said radially inner surface from the second axial end is at least partially directed back through the second axial end of the generally tubular body.

The apparatus according to the first aspect may be referred to as a flow cone.

In use, the generally tubular body may be disposed in a central aperture of a collector reflector. The collector reflector may be a concave or bowl-shaped mirror with a central aperture. In particular, a reflective surface of the collector reflector may be generally of the form of a portion of an ellipsoid. In use, laser radiation may be directed from a side of the collector reflector that is distal its reflective surface (the rear side of the collector) to a side of the collector reflector that defines its reflective surface (the front side of the collector). The laser radiation may comprise infrared radiation. The laser radiation may be incident on a fuel target (for example a tin target), which may cause the fuel target to at least partially form a plasma that emits radiation (for example extreme ultraviolet, EUV, radiation). This may occur at a first focal position of the generally ellipsoidal reflective surface and the reflective surface may focus radiation emitted by the plasma at a second focal position of the reflective surface.

The laser radiation may be focused at or near the first focal position by a focusing unit. Between the focusing unit and the first focal position, the laser radiation may propagate from the focusing unit (on the rear side of the collector) through the inner tubular portion from the first axial end of the body to the second axial end of the body (to the front side of the collector).

Note that the laser radiation may comprise a plurality of pulses, each of which is incident on the fuel target. For example, one or more shaping pulses may be incident on the fuel target in order to modify a shape of the target before a main pulse is incident on the fuel target to generate the plasma. The one or more shaping pulses may be arranged to modify a shape of the target so as to optimize or maximize a conversion efficiency of the main pulse laser radiation energy into the EUV radiation.

The apparatus according to the first aspect (which may be referred to as a flow cone) fulfills a number of functions. First, an interior of the inner tubular portion provides an aperture through which the laser radiation can propagate towards the first focal position. Second, it guides a flow of gas (for example hydrogen) that can at least partially protect one or more surfaces (in particular the reflective surface of the collector reflector) from damage from fuel debris. In particular, such a flow of gas may be provided via the fluid passageway defined between the inner tubular portion and the outer tubular portion from the inlet at the first axial end to the outlet proximate to the second axial end. This flow of gas may flow generally radially outwards from the axis across a surface of the collector reflector. It will be appreciated that such a flow of gas may be also provided through the interior of the inner tubular portion (from a rear side of the collector reflector to the front side of the collector reflector).

The structure provided on the radially inner surface of the generally tubular body is advantageous as it can reduce the amount of laser radiation that is scattered back through generally tubular body from the front side of the reflector collector (in the LPP source vessel) back towards the focusing unit. Such laser radiation (which may be referred to as "stray light") may be reflected from various different surfaces within the source vessel. It is desirable to minimize the amount of stray light that is reflected back towards the focusing unit because: (a) stray light can cause components of the focusing unit to overheat; and (b) stray light can cause a background to various metrology signals. Stray light may propagate from the source vessel towards the focusing unit either directly or indirectly, reflecting from a radially inner surface of the flow cone. It has been found that, for some known arrangements, a significant amount of the stray light (for example around 50% of it) reaches the focusing unit indirectly via the radially inner surface of the flow cone. Advantageously, the structure provided on the radially inner surface of the generally tubular body of the apparatus according to the first aspect will reduce the amount of such indirect stray light that reaches the focusing unit.

In some embodiments, the structure may be provided on a radially inner surface of the inner tubular portion.

In some embodiments, the apparatus according to the first aspect of the present disclosure may further comprise a collector generally surrounding the generally tubular body, the collector may be provided with a reflective surface facing a volume that is adjacent to the second axial end of the generally tubular body.

The collector may generally surround the generally tubular body circumferentially. The collector may be a concave or bowl-shaped mirror with a central aperture. In particular, a reflective surface of the collector reflector may be generally of the form of a portion of an ellipsoid. Such a collector may define first and second focal positions. The collector may be arranged to receive radiation from the first focal position and to focus it at the second focal position.

According to a second aspect of the present disclosure there is provided an apparatus for a laser-produced plasma radiation source, the apparatus comprising: a collector, the collector provided with a concave reflective surface with a central aperture; and; a generally tubular body defining an axis and extending from a first axial end to a second axial end, the generally tubular body disposed in the central aperture of the collector, the concave reflective surface of the collector facing a volume that is adjacent to the second axial end of the generally tubular body; and wherein a radially inner surface of the generally tubular body is provided with a structure configured such that radiation received by said radially inner surface from the second axial end is at least partially directed back through the second axial end of the generally tubular body.

The reflective surface of the collector may be generally of the form of a portion of an ellipsoid. Such a collector may define first and second focal positions. The collector may be arranged to receive radiation from the first focal position and to focus it at the second focal position.

In use, laser radiation may be directed from a side of the collector reflector that is distal its reflective surface (the rear side of the collector) to a side of the collector reflector that defines its reflective surface (the front side of the collector). The laser radiation may comprise infrared radiation. The laser radiation may be incident on a fuel target (for example a tin target), which may cause the fuel target to at least partially form a plasma that emits radiation (for example extreme ultraviolet, EUV, radiation). This may occur at a first focal position of the generally ellipsoidal reflective surface and the reflective surface may focus radiation emitted by the plasma at a second focal position of the reflective surface.

The laser radiation may be focused at or near the first focal position by a focusing unit. Between the focusing unit and the first focal position, the laser radiation propagates from the focusing unit (on the rear side of the collector) through the generally tubular body from the first axial end of the body to the second axial end of the body (to the front side of the collector). The generally tubular body may be referred to as a flow cone.

Note that the laser radiation may comprise a plurality of pulses, each of which is incident on the fuel target. For example, one or more shaping pulses may be incident on the fuel target in order to modify a shape of the target before a main pulse is incident on the fuel target to generate the plasma. The one or more shaping pulses may be arranged to modify a shape of the target so as to optimize or maximize a conversion efficiency of the main pulse laser radiation energy into the EUV radiation.

The apparatus according to the second aspect of the present disclosure is advantageous, as now discussed. The structure provided on the radially inner surface of the generally tubular body can reduce the amount of laser radiation that is scattered back through the generally tubular body from the front side of the reflector collector (in the LPP source vessel) back towards the focusing unit. Such laser radiation (which may be referred to as "stray light") may be reflected from various different surfaces within the source vessel. It is desirable to minimize the amount of stray light that is reflected back towards the focusing unit because: (a) stray light can cause components of the focusing unit to overheat; and (b) stray light can cause a background to various metrology signals. Stray light may propagate from the source vessel towards the focusing unit either directly or indirectly, reflecting from a radially inner surface of the flow cone (generally tubular body). It has been found that, for some known arrangements, a significant amount of the stray light (for example around 50% of it) reaches the focusing unit indirectly via the radially inner surface of the flow cone. Advantageously, the structure provided on the radially inner surface of the generally tubular body of the apparatus according to the second aspect will reduce the amount of such indirect stray light that reaches the focusing unit.

In some embodiments of the apparatus according to the second aspect of the present disclosure, the generally tubular body may comprise an inner tubular portion and an outer tubular portion surrounding the inner tubular portion so as to define a volume therebetween. The volume defining a fluid passageway may extend from an inlet at the first axial end to an outlet proximate to the second axial end. The inner tubular portion and the outer tubular portion may be arranged such that the outlet of the fluid passageway directs fluid received at the inlet generally radially outwards from the axis.

For such embodiments, the structure may be provided on a radially inner surface of the inner tubular portion.

The structure provided on the radially inner surface of the generally tubular body may be such that a greater portion of the radiation received by said radially inner surface from the second axial end is directed back through the second axial end of the generally tubular body than would be directed back through the second axial end of the generally tubular body by a smooth or flat radially inner surface of the generally tubular body.

That is, more radiation is reflected back towards the source vessel (the front of the collector) than would be the case if the interior surface of the flow cone was smooth or flat.

The structure provided on the radially inner surface of the generally tubular body may be configured so as to maximize a portion of the radiation received by said radially inner surface from the second axial end that is directed back through the second axial end of the generally tubular body.

It will be appreciated that as used here maximizing the portion of the radiation received by said radially inner surface from the second axial end that is directed back through the second axial end of the generally tubular body is not intended to be limited to a perfect maximization but rather an arrangement which is close to, for example within 10% of, such a perfect maximization.

In some embodiments, the structure provided on the radially inner surface of the generally tubular body may comprise features with dimensions that are significantly larger than a wavelength of the laser radiation. Additionally or alternatively, in some embodiments, the structure provided on the radially inner surface of the generally tubular body may comprise features with dimensions that are of the same order of magnitude as a wavelength of the laser radiation. The wavelength of the laser radiation may generally be of the order of 1-10 µm. Specific examples of the wavelength of the laser radiation include: within 10% of 1 µm ; within 10% of 2 µm; and within 10% of 10 µm.

The structure provided on the radially inner surface of the generally tubular body may comprise a sawtooth profile in cross section in a plane parallel to the axis.

For example, the sawtooth profile may comprise a plurality of grooves formed on the radially inner surface of the generally tubular body. With such a sawtooth profile, the structure may be considered to comprise a plurality of (generally frustoconical) facets. At least some of these facets may be arranged, or angled, so as to redirect radiation they receive from the second axial end (i.e. from the front of the collector) preferentially back through the second axial end of the generally tubular body. Such arrangements may result in specular reflection of the radiation received from the second axial end of the generally tubular body to be preferentially directed back through the second axial end of the generally tubular body.

In such embodiments, the sawtooth profile may comprise dimensions that are significantly larger than a wavelength of the laser radiation. The wavelength of the laser radiation may generally be of the order of 1-10 µm. Specific examples of the wavelength of the laser radiation include: within 10% of 1 µm; within 10% of 2 µm; and within 10% of 10 µm.

The structure provided on the radially inner surface of the generally tubular body may comprise a plurality of facets and adjacent pairs of facets may be disposed at different angles in a plane parallel to the axis.

The plurality of facets may be generally frustoconical.

The structure provided on the radially inner surface of the generally tubular body may comprise a plurality of generally frustoconical facets.

At least some of these facets may be arranged, or angled, so as to redirect radiation they receive from the second axial end (i.e. from the front of the collector) preferentially back through the second axial end of the generally tubular body. Such arrangements may result in specular reflection of the radiation received from the second axial end of the generally tubular body to be preferentially directed back through the second axial end of the generally tubular body.

The structure provided on the radially inner surface of the generally tubular body may comprise surface roughness.

Such arrangements may result in diffuse reflection of the radiation received from the second axial end of the generally tubular body. In turn, this may reduce the amount of such radiation that reaches the first axial end of the generally tubular body (and increases the amount which is directed back through the second axial end of the generally tubular body).

The structure provided on the radially inner surface of the generally tubular body may comprise a diffraction grating.

It will be appreciated that the direction in which each diffraction order radiation is scattered by a diffraction grating is dependent on: an angle of incidence of the incident radiation; the wavelength of the incident radiation; and a pitch of the diffraction grating. It will be appreciated that diffraction efficiencies (i.e. how much of the incident radiation is scattered into each diffraction order) of a diffraction grating are dependent on a shape of a unit call of the diffraction grating.

The diffraction grating may be configured such that the diffraction efficiencies and the directions of the diffraction orders generated by radiation received from the second axial end are such that the amount of radiation directed back out of the second axial end is optimized or maximized.

In such embodiments, the structure provided on the radially inner surface of the generally tubular body may comprise features with dimensions that are of the same order of magnitude as a wavelength of the laser radiation. The wavelength of the laser radiation may generally be of the order of 1-10 µm. Specific examples of the wavelength of the laser radiation include: within 10% of 1 µm; within 10% of 2 µm; and within 10% of 10 µm.

In some embodiments, the apparatus according to the first and/or second aspect of the present disclosure may further comprise a gas source operable to deliver gas to the inlet of the fluid passageway defined between the inner tubular portion and the outer tubular portion.

The gas delivered to the inlet of the fluid passageway may flow along the fluid passageway from the inlet (at the first axial end) to the outlet proximate to the second axial end, where it may be directed radially outwards from the axis.

The structure provided on the radially inner surface of the generally tubular body may comprise features with dimensions that are significantly smaller than an inner diameter of the generally tubular body.

According to a third aspect of the present disclosure there is provided a laser-produced plasma radiation source comprising: an apparatus according to the first and/or second aspect of the present disclosure; a fuel target generator operable to generate a stream of fuel targets that propagate along a fuel trajectory; and a laser system operable to direct laser radiation through the generally tubular body from the first axial end of the body to the second axial end of the body so as to intercept the fuel traj ectory.

As explained above, the laser radiation is incident on the fuel targets (for example a tin targets), which may cause the fuel target to at least partially form a plasma that emits radiation (for example extreme ultraviolet, EUV, radiation). The interception of the laser radiation and the fuel trajectory may coincide with a first focal position of a collector of the laser-produced plasma source.

The laser radiation may comprise infrared radiation. The laser radiation may have a wavelength of the order of 1-10 µm. Specific examples of the wavelength of the laser radiation include: within 10% of 1 µm; within 10% of 2 µm; and within 10% of 10 µm.

The structure provided on the radially inner surface of the generally tubular body may comprise features with dimensions that are significantly larger than a wavelength of the laser radiation.

Such embodiments may use such features to direct radiation received from the second axial end back towards the second axial end via specular reflection.

The structure provided on the radially inner surface of the generally tubular body may comprise features with dimensions that are of the same order of magnitude as a wavelength of the laser radiation.

Such embodiments may use such features to cause diffraction of radiation received from the second axial end. The features may be configured such that such radiation diffracted by such features is preferentially directed back towards the second axial end.

The laser-produced plasma radiation source may further comprise a source vessel arranged to at least partially define a volume that is adjacent to the second axial end of the generally tubular body.

The source vessel may comprise a vessel wall, at least a portion of which may be provided with a laser light absorbing inside surface.

According to a fourth aspect of the present disclosure there is provided an exposure apparatus comprising the laser-produced plasma radiation source according to the third aspect of the present disclosure.

The exposure apparatus may comprise any apparatus for exposing an object to a dose of radiation. The exposure apparatus may comprise a lithographic apparatus (also known as a scanner). Alternatively, the exposure apparatus may comprise a metrology apparatus, for example for measuring overlay. Alternatively, the exposure apparatus may comprise an inspection apparatus, for example an actinic mask inspection apparatus.

In a fifth aspect, the present disclosure relates to a method of generating plasma radiation, such as EUV radiation. The method comprises providing laser-produced plasma radiation source according to the third aspect of the present disclosure; directing the stream of fuel targets along the fuel trajectory; directing the laser radiation through the generally tubular body from the first axial end of the body to the second axial end of the body whereby intercepting the fuel trajectory, whereby at least part of the laser radiation is incident on at least one of the fuel targets thereby forming a plasma that emits plasma radiation; and at least partially direct back, through the second axial end of the generally tubular body, radiation that is received by the radially inner surface from the second axial end with the structure configured thereon.

By directing back radiation, which otherwise would have reflected off of the radially inner surface of the generally tubular body, the amount of radiation that is allowed into area adjacent to the first axial end of the generally tubular body is reduced. Herewith, any interference with components or equipment in that area is also reduced. For example, in case there is a focusing unit in that area, it is desirable to minimize the amount of laser radiation that is reflected back towards the focusing unit as such radiation can cause components of the focusing unit to overheat. In another example, in case there is a metrology unit in that area, can such undesired back directed laser radiation could cause a background to various metrology signals.

The radiation that is at least partially directed back includes a portion of the laser radiation, more specifically stray light of the laser radiation. The laser radiation may have a wavelength of the order of 1-10 µm. Specific examples of the wavelength of the laser radiation include: within 10% of 1 µm; within 10% of 2 µm; and within 10% of 10 µm.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a system for (actinic) mask inspection;
- Figure 3 schematically shows a first apparatus for use in a laser-produced plasma radiation source according to an embodiment of the present disclosure;
- Figure 4A schematically shows a modified version of the apparatus shown in Figure 3 wherein a radially inner surface of the generally tubular body is not provided with a structure (i.e. the radially inner surface is smooth wherein radiation is incident on the radially inner surface of the generally tubular body from a second axial end, is reflected from the inner radial surface, and is directed out of the generally tubular body through the first axial end;
- Figure 4B schematically shows the radially inner surface of the generally tubular body of the apparatus shown in any one of Figures 3, 5 or 6, which is provided with a structure wherein radiation is incident on the radially inner surface, is scattered from the structure, and is directed out of the generally tubular body back through the second axial end.
- Figure 5 schematically shows a second apparatus for use in a laser-produced plasma radiation source according to an embodiment of the present disclosure;
- Figure 6 schematically shows a third apparatus for use in a laser-produced plasma radiation source according to an embodiment of the present disclosure; and
- Figure 7 schematically shows a laser-produced plasma radiation source according to an embodiment of the present disclosure that comprises the apparatus shown in one of Figures 3 to 6.

### DETAILED DESCRIPTION

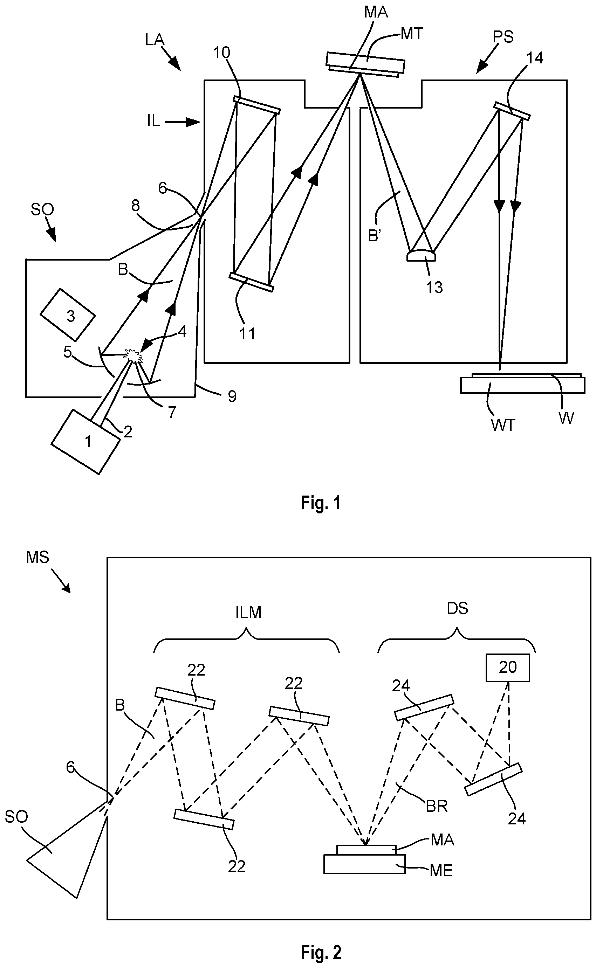

Figure 1 schematically shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel (i.e., a target material), such as tin (Sn) which is provided from, e.g., a target material supply system 3. Although tin is referred to in the following description, any suitable fuel may be used. The fuel may, for example, be in liquid form, and may, for example, be a metal or alloy. The target material supply system 3 may comprise a target material output, e.g. a nozzle configured to direct the target material, e.g. in the form of droplets, along a trajectory towards a plasma formation region 4. The laser beam 2 is incident upon the fuel at the plasma formation region 4. The deposition of laser energy into the target material creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Figure 2 schematically depicts a mask inspection system MS for (actinic) mask inspection. The mask inspection system MS can be used to identify or inspect defects in a mask to be used in a lithographic process by means of the lithographic apparatus described in figure 1. The mask inspection system MS comprises a radiation source SO, an illumination system ILM, a detection system DS and a mask stage ME.

The illumination system ILM is configured to condition an EUV radiation beam B before the EUV radiation beam B is incident upon a mask MA supported by the mask stage ME. The illumination system ILM may provide the EUV radiation beam B with a desired cross-sectional shape and a desired intensity distribution. The illumination system ILM may comprise a plurality of mirrors 22. The illumination system ILM may comprise one or more faceted mirror devices.

The mask stage ME may be configured to support and move a mask MA relative to the EUV radiation beam B, so that the EUV radiation beam is incident upon different areas of the mask.

The detection system DS comprises a detector 20, and may in addition comprise a plurality of mirrors 24. The plurality of mirrors 24 may be configured to collect EUV radiation BR that has been reflected from the mask MA, and form an image of the mask MA on the detector 20 (which may be an imaging array). A processor (not depicted) may receive signals output from the detector 20 and use those signals to look for defects in the mask MA.

The radiation source SO of the mask inspection system MS may correspond with the radiation source SO depicted in Figure 1. In the same way as depicted in Figure 1, the radiation source SO of the mask inspection system MS may focus the EUV radiation beam B to form an intermediate focus 6.

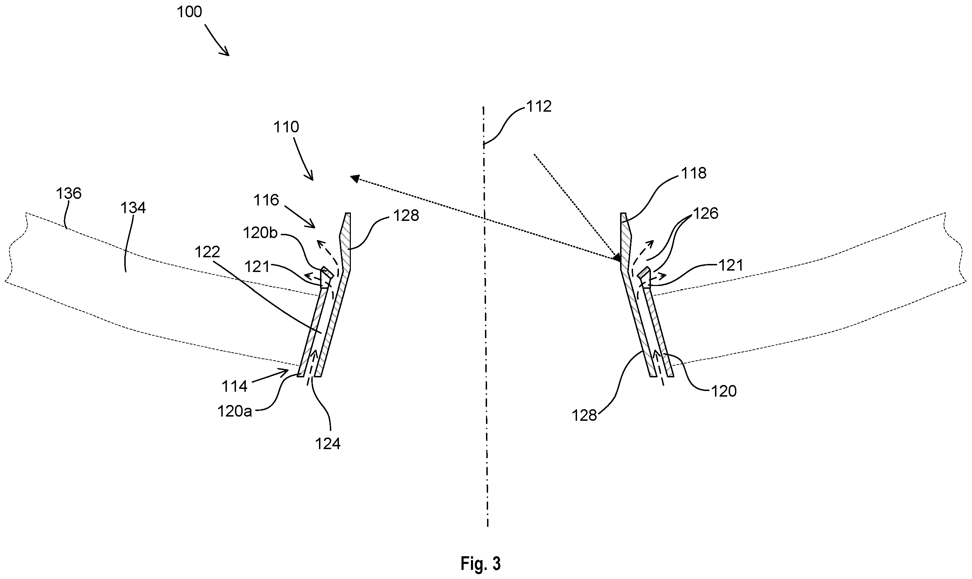

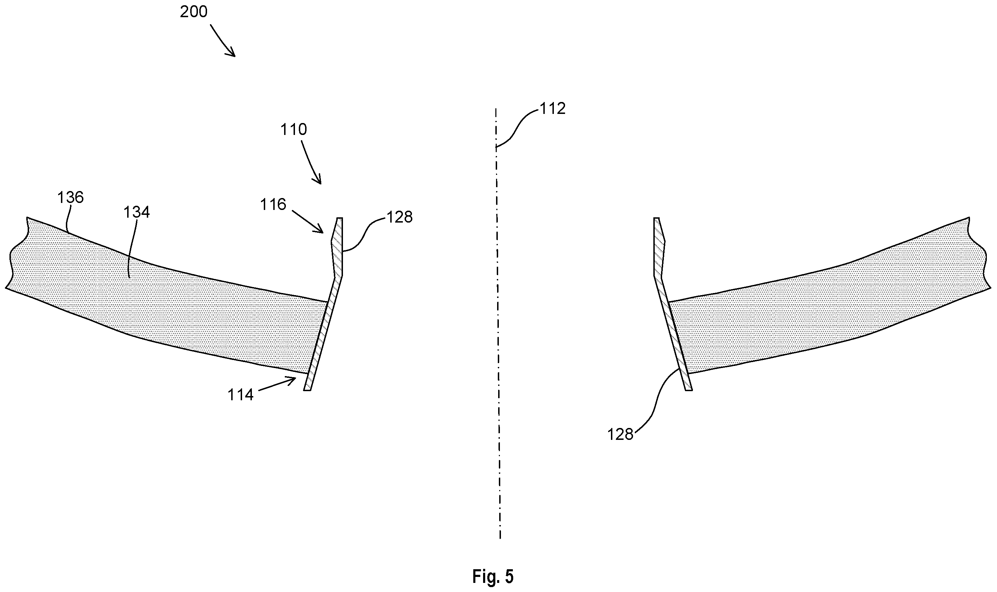

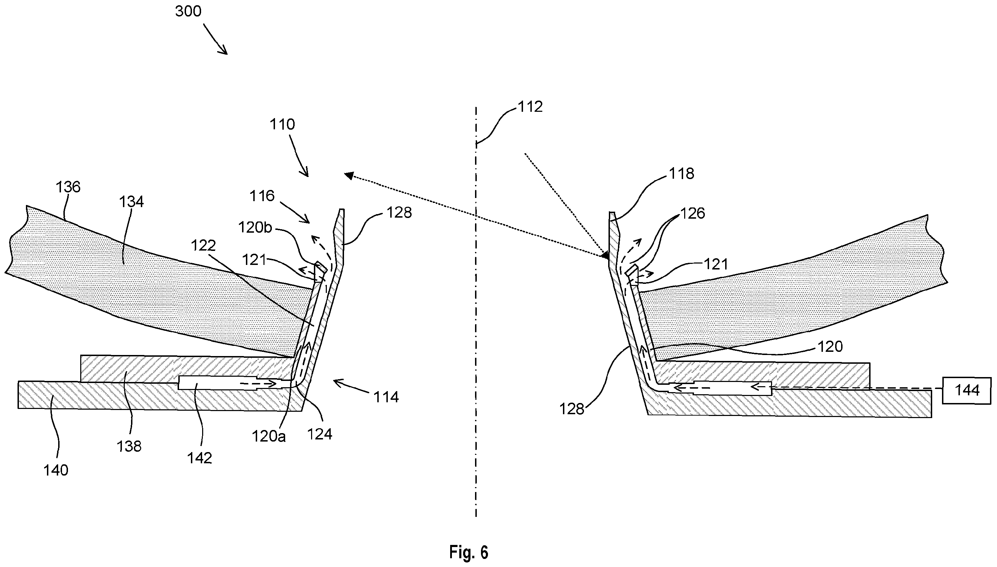

Some embodiments of the present disclosure relate to an apparatus for a laser-produced plasma radiation source. A first example embodiment of an apparatus 100 for a laser-produced plasma radiation source is shown in Figure 3. A second example embodiment of an apparatus 200 for a laser-produced plasma radiation source is shown in Figure 5. The two apparatus 100, 200 may share some features in common and such common features share common reference numerals. A third example embodiment of an apparatus 300 for a laser-produced plasma radiation source is shown in Figure 6; the third embodiment of an apparatus 300 for a laser-produced plasma radiation source shown in Figure 6 is a combination of the two embodiments 100, 200 shown in Figures 3 and 5.

Figure 3 shows a schematic cross sectional view of a first apparatus 100 for a laser-produced plasma radiation source. The apparatus 100 comprises a generally tubular body 110 defining an axis 112 and extending from a first axial end 114 to a second axial end 116.

The generally tubular body 110 comprises an inner tubular portion 118 and an outer tubular portion 120 surrounding the inner tubular portion 118 so as to define a volume 122 therebetween. The volume 122 define a fluid passageway extending from an inlet 124 at the first axial end 114 to an outlet 126 proximate to the second axial end 116. As explained further below, in this embodiment the outlet 126 comprises more than one outlet passage

The inner tubular portion 118 and the outer tubular portion 120 are arranged such that the outlet 126 of the fluid passageway 122 directs fluid received at the inlet 124 generally radially outwards from the axis 112. This is indicated schematically in Figure 3 by dashed arrows showing such fluid flow.

A first portion of the fluid flowing from the inlet 124 is directed through a gap between the inner tubular portion 118 and the outer tubular portion 120 at the second axial end 116. A portion of the inner tubular portion 118 proximate the second axial end 116 is shaped so as to act as a baffle to direct the first portion in a more radial direction as it exits the outlet 126.

In this embodiment, the outer tubular portion 120 comprises a main portion 120a and a distal end portion 120b proximate the second axial end. An axial gap is defined between the main portion 120a and the distal end portion 120b around a majority of the circumference of the outer tubular portion 120. The main portion 120a is connected to, and supports, the distal end portion 120b via a plurality of (axially extending) supports 121 arranged around the circumference of the outer tubular portion 120. The cross section shown in Figure 3 passes through the axial gap (between the main portion 120a and the distal end portion 120b) on either side of the axis 112. Two of the supports 121 can be seen (not in cross section) in Figure 3 (one on each side of the axis 112). The plurality of supports 121 divides the axial gap (between the main portion 120a and the distal end portion 120b) into a plurality of portions (or a plurality of passageways), each one defined between a pair of circumferentially adjacent supports 121.

A second portion of the fluid flowing from the inlet 124 is directed through the portions of the axial gap between the main portion 120a and the distal end portion 120b of the outer tubular portion 120 (in flow passages defined between the circumferentially spaced supports 121). The distal end portion 120b is arranged to act as a baffle to direct the second portion in a more radial direction as it exits the outlet 126.

It will be appreciated that in alternative embodiments, the outlet 126 may comprise a different number or configuration of passageways for the fluid to exit the outlet 126 generally radially outwards from the axis 112.

As will be discussed further below, a radially inner surface 128 of the generally tubular body 110 is provided with a structure that is configured such that radiation received by said radially inner surface 128 from the second axial end 116 is at least partially directed back through the second axial end 116 of the generally tubular body 110. This is indicated schematically in Figure 3 by dotted arrows showing such radiation received by the radially inner surface 128.

The inner tubular portion 118 has a radially outer surface which faces the outer tubular body 120 and the radially inner surface 128 which faces the axis 112.

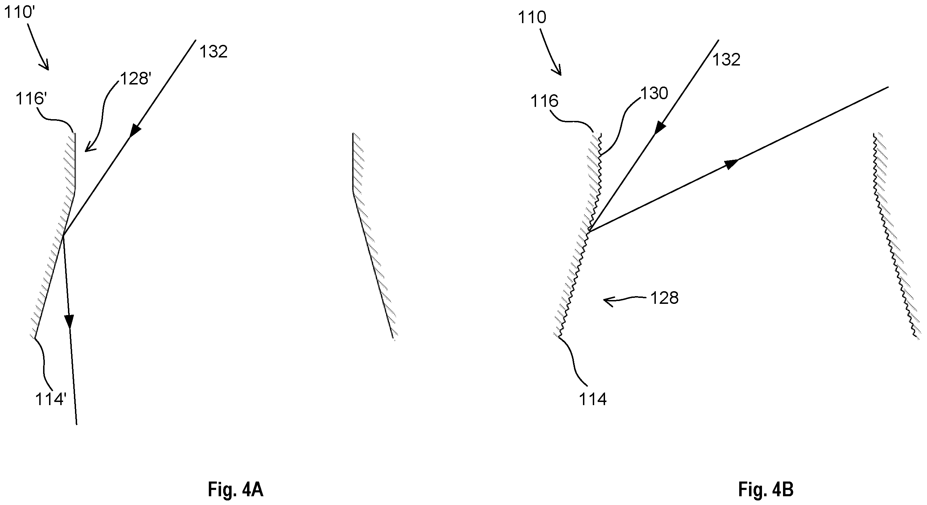

An example of such a structure 130, and how it can increase a fraction of radiation received by said radially inner surface 128 from the second axial end 116 that is directed back through the second axial end 116 of the generally tubular body 110 (relative to an arrangement wherein the radially inner surface 128 is smooth) is shown schematically in Figures 4A and 4B.

Figure 4A schematically shows an arrangement 110' (a modified version of the apparatus 100) wherein the radially inner surface 128' of the generally tubular body 110' is not provided with a structure (i.e. the radially inner surface 128' is smooth). As shown in Figure 4A, radiation 132 is incident on a radially inner surface 128' of the generally tubular body 110' of the modified version of the apparatus from a second axial end 116'. The radiation 130 is reflected from the inner radial surface 128' and is directed out of the generally tubular body through the first axial end 114'.

Figure 4B schematically shows the radially inner surface 128 of the generally tubular body 110 of the apparatus 100 of Figure 3 (or the apparatus 200, 300 shown in Figures 5 and 6) which is provided with a structure 130. As shown in Figure 4A, when the same radiation 132 is incident on a radially inner surface 128 of the generally tubular body 110 of the apparatus 100 shown in Figure 3 (or the apparatus 200, 300 shown in Figures 5 and 6) from the second axial end 116, the radiation 130 is scattered from the structure 130 and is directed out of the generally tubular body back through the second axial end 116.

The apparatus 100 shown in Figure 3 may be referred to as a flow cone. The apparatus 100 shown in Figure 3 may form part of a laser-produced plasma radiation source that may be generally of the form of the radiation source shown in Figure 1 and as described above.

In use, the generally tubular body may be disposed in a central aperture of a collector reflector 134 (shown in dashed lines in Figure 3). The collector reflector 134 may correspond generally to the collector 5 shown in Figure 1. The collector reflector 134 may be a concave or bowl-shaped mirror with a central aperture. In particular, a reflective surface 136 of the collector reflector 134 may be generally of the form of a portion of an ellipsoid. As described above with reference to Figure 1, in use, laser radiation may be directed from a side of the collector reflector 134 that is distal its reflective surface 136 (the rear side of the collector 134) to a side of the collector reflector 134 that defines its reflective surface 136 (the front side of the collector 134). The laser radiation may comprise infrared radiation. The laser radiation may be incident on a fuel target (for example a tin target), which may cause the fuel target to at least partially form a plasma that emits radiation (for example extreme ultraviolet, EUV, radiation). This may occur at a first focal position of the generally ellipsoidal reflective surface 136 and the reflective surface 136 may focus radiation emitted by the plasma at a second focal position of the reflective surface 136. The first focal position may correspond generally to the plasma formation region 4 shown in Figure 1 and the second focal position may correspond generally to the intermediate focus 6 shown in Figure 1.

The laser radiation may be focused at or near the first focal position by a focusing unit. Between the focusing unit and the first focal position, the laser radiation may propagate from the focusing unit (on the rear side of the collector 134) through the inner tubular portion 118 from the first axial end 114 of the body 110 to the second axial end 116 of the body 110 (to the front side of the collector 134).

Note that the laser radiation may comprise a plurality of pulses, each of which is incident on the fuel target. For example, one or more shaping pulses may be incident on the fuel target in order to modify a shape of the target before a main pulse is incident on the fuel target to generate the plasma. The one or more shaping pulses may be arranged to modify a shape of the target so as to optimize or maximize a conversion efficiency of the main pulse laser radiation energy into the EUV radiation.

The apparatus 100 shown in Figure 3 (which may be referred to as a flow cone) fulfills a number of functions. First, an interior of the inner tubular portion 118 provides an aperture through which the laser radiation can propagate towards the first focal position. Second, it guides a flow of gas (for example hydrogen) that can at least partially protect one or more surfaces (in particular the reflective surface 136 of the collector reflector 134) from damage from fuel debris. In particular, such a flow of gas may be provided via the fluid passageway 122 defined between the inner tubular portion 118 and the outer tubular portion 120 from the inlet 124 at the first axial end 114 to the outlet 126 proximate to the second axial end 116. This flow of gas may flow generally radially outwards from the axis 112 across a surface 136 of the collector reflector 134. It will be appreciated that such a flow of gas may be also provided through the interior of the inner tubular portion 120 (from a rear side of the collector reflector 134 to the front side of the collector reflector 134).

The structure 130 provided on the radially inner surface of the generally tubular body 110 is advantageous as it can reduce the amount of laser radiation that is scattered back through generally tubular body 110 from the front side of the reflector collector 134 (in the LPP source vessel) back towards the focusing unit. Such laser radiation (which may be referred to as "stray light") may be reflected from various different surfaces within the source vessel. It is desirable to minimize the amount of stray light that is reflected back towards the focusing unit because: (a) stray light can cause components of the focusing unit to overheat; and (b) stray light can cause a background to various metrology signals. Staylight may propagate from the source vessel towards the focusing unit either directly or indirectly, reflecting from a radially inner surface 128' of the flow cone (see Figure 4A). It has been found that, for some known arrangements, a significant amount of the stray light (for example around 50% of it) reaches the focusing unit indirectly via the radially inner surface 128' of the flow cone. Advantageously, the structure 130 provided on the radially inner surface 128 of the generally tubular body 110 of the apparatus 100 shown in Figure 3 will reduce the amount of such indirect stray light that reaches the focusing unit.

In some embodiments, the structure 130 may be provided on a radially inner surface of the inner tubular portion 118.

Optionally, the apparatus 100 shown in Figure 3 may further comprise a collector 134 generally surrounding the generally tubular body 110, the collector 134 provided with a reflective surface 136 facing a volume that is adjacent to the second axial end 116 of the generally tubular body 110. The collector 134 may generally surround the generally tubular body 110 circumferentially. The collector 134 may be a concave or bowl-shaped mirror with a central aperture. In particular, a reflective surface 136 of the collector reflector 134 may be generally of the form of a portion of an ellipsoid. Such a collector 134 may define first and second focal positions. The collector 134 may be arranged to receive radiation from the first focal position and to focus it at the second focal position.

Figure 5 shows a schematic cross sectional view of a second apparatus 200 for a laser-produced plasma radiation source. The apparatus 200 comprises a collector 134 and a generally tubular body 110. The collector 134 is provided with a concave reflective surface 136 and comprises a central aperture. It will be appreciated that only a relatively small portion of the collector 134 mirror is shown in Figure 5.

The generally tubular body 110 defines an axis 112 and extends from a first axial end 114 to a second axial end 116. The generally tubular body 110 is disposed in the central aperture of the collector 134. The concave reflective surface 136 of the collector 134 faces a volume that is adjacent to the second axial end 116 of the generally tubular body 110.

A radially inner surface 128 of the generally tubular body 110 is provided with a structure 130 (see, for example, Figure 4B) that is configured such that radiation received by said radially inner surface 128 from the second axial end 116 is at least partially directed back through the second axial end 116 of the generally tubular body 110.

The collector 134 may be generally of the form described above with reference to Figure 3. As explained above with reference to Figures 1 and 3, in use, laser radiation may be directed from a side of the collector reflector 134 that is distal its reflective surface 136 (the rear side of the collector 134) to a side of the collector reflector 134 that defines its reflective surface 136 (the front side of the collector 134).

The apparatus 200 shown in Figure 5 is advantageous, since the structure 130 provided on the radially inner surface 128 of the generally tubular body 110 can reduce the amount of laser radiation that is scattered back through the generally tubular body 110 from the front side of the reflector collector 134 (in the LPP source vessel) back towards a focusing unit of a laser-produced plasma radiation source. Such laser radiation (which may be referred to as "stray light") may be reflected from various different surfaces within the source vessel. It is desirable to minimize the amount of stray light that is reflected back towards the focusing unit because: (a) stray light can cause components of the focusing unit to overheat; and (b) stray light can cause a background to various metrology signals. Staylight may propagate from the source vessel towards the focusing unit either directly or indirectly, reflecting from a radially inner surface 128' of a flow cone (generally tubular body, see Figure 4A). It has been found that, for some known arrangements, a significant amount of the stray light (for example around 50% of it) reaches the focusing unit indirectly via the radially inner surface of the flow cone. Advantageously, the structure 130 provided on the radially inner surface 128 of the generally tubular body 100 of the apparatus 200 shown in Figure 5 will reduce the amount of such indirect stray light that reaches the focusing unit.

Optionally, the generally tubular body 110 of the apparatus 200 shown in Figure 5 may comprise an inner tubular portion 118 and an outer tubular portion 120 arranged in a similar way to the generally tubular body 110 of the apparatus 100 shown in Figure 3.

Figure 6 shows a third apparatus 300 for a laser-produced plasma radiation source, which is a combination of the two embodiments 100, 200 shown in Figures 3 and 5. The apparatus 300 shown in Figure 6 also has some additional features, as now discussed.

The inner tubular portion 118 further comprises a first flange 138 at the first axial end 114. The first flange 138 is generally annular and extends radially away from the axis 112. Similarly, the outer tubular portion 120 further comprises a second flange 140 at the first axial end 114. The second flange 138 is generally annular and extends radially away from the axis 112.

A portion of the first flange 138 is adjacent to, and in contact with, a portion of the second flange 140. The first flange 138 may be attached to the second flange 140 via these portions. Such attachment may be achieved with any convenient type of attachment means. The attachment means may, for example, comprise a mechanical attachment such as, for example, screws, bolts, rivets or the like. Alternatively, the attachment means may comprise an adhesive.

The first and second flanges 138, 140 are shaped so as to define a chamber 142 together. The chamber 142 is generally toroidal and generally surrounds the axis 112. The chamber 142 is in fluid communication with the inlet 124 of the fluid passageway 122 defined between the inner tubular portion 118 and the outer tubular portion 120. In use, gas can flow radially inwards from the chamber 142 to the fluid passageway 122 defined between the inner tubular portion 118 and the outer tubular portion 120, as indicated by a dashed arrow in Figure 6.

Although not shown in the cross section of Figure 6, the first and second flanges 138, 140 are shaped so as to define at least one inlet channel that is in fluid communication with the chamber 142 and which is radially outboard of the chamber 142.

Optionally, the apparatus 300 may further comprise a gas source 144 operable to deliver gas to the inlet 124 of the fluid passageway 122 defined between the inner tubular portion 118 and the outer tubular portion 120. The gas may flow radially inwards (via one or more inlet channels defined by the first and second flanges 138, 140) to the chamber 142 and then into the flow passage 122. The gas delivered to the inlet 124 of the fluid passageway 122 may flow along the fluid passageway 122 from the inlet 124 (at the first axial end 114) to the outlet 126 proximate to the second axial end 116, where it may be directed radially outwards from the axis 112.

A number of optional features that any one of the apparatus 100, 200, 300 shown in Figures 3 to 6 may comprise are now discussed.

In some embodiments, the structure 130 provided on the radially inner surface 128 of the generally tubular body 110 may be such that a greater portion of the radiation 130 received by said radially inner surface 120 from the second axial end 116 is directed back through the second axial end 116 of the generally tubular body 110 than would be directed back through the second axial end 116 of the generally tubular body 110 by a smooth or flat radially inner surface 128' of the generally tubular body 110'. That is, more radiation is reflected back towards the source vessel (the front of the collector 134) than would be the case if the interior surface of the flow cone was smooth or flat.

In some embodiments, the structure 130 provided on the radially inner surface 128 of the generally tubular body 110 is configured so as to maximize a portion of the radiation 130 received by said radially inner surface 128 from the second axial end 116 that is directed back through the second axial end 116 of the generally tubular body 110. It will be appreciated that as used here maximizing the portion of the radiation 130 received by said radially inner surface 128 from the second axial end that is directed back through the second axial end 116 of the generally tubular body 110 is not intended to be limited to a perfect maximization. Rather, as used here, maximization is intended to mean an arrangement which is close to, for example within 10% of, such a perfect maximization.

In some embodiments, the structure 130 provided on the radially inner surface 128 of the generally tubular body 110 may comprise features with dimensions that are significantly larger than a wavelength of the laser radiation. Additionally or alternatively, in some embodiments, the structure 130 provided on the radially inner surface 128 of the generally tubular body 110 may comprise features with dimensions that are of the same order of magnitude as a wavelength of the laser radiation. The wavelength of the laser radiation may generally be of the order of 1-10 µm. Specific examples of the wavelength of the laser radiation include: within 10% of 1 µm ; within 10% of 2 µm ; and within 10% of 10 µm.

In some embodiments, the structure 130 provided on the radially inner surface 128 of the generally tubular body 110 may comprise a sawtooth profile in cross section in a plane parallel to the axis 112.

For example, the sawtooth profile may comprise a plurality of grooves formed on the radially inner surface 128 of the generally tubular body 110. With such a sawtooth profile, the structure 130 may be considered to comprise a plurality of (generally frustoconical) facets. At least some of these facets may be arranged, or angled, so as to redirect radiation 130 they receive from the second axial end 116 (i.e. from the front of the collector 134) preferentially back through the second axial end 116 of the generally tubular body 110. Such arrangements may result in specular reflection of the radiation 130 received from the second axial end 116 of the generally tubular body 110 to be preferentially directed back through the second axial end 116 of the generally tubular body 110.

In such embodiments, the sawtooth profile may comprise dimensions that are significantly larger than a wavelength of the laser radiation. The wavelength of the laser radiation may generally be of the order of 1-10 µm. Specific examples of the wavelength of the laser radiation include: within 10% of 1 µm; within 10% of 2 µm; and within 10% of 10 µm.

In some embodiments, the structure 130 provided on the radially inner surface 128 of the generally tubular body 110 may comprise a plurality of facets. Adjacent pairs of facets may be disposed at different angles in a plane parallel to the axis 112. The plurality of facets may be generally frustoconical.

In some embodiments, the structure 130 provided on the radially inner surface 128 of the generally tubular body 110 may comprise a plurality of generally frustoconical facets. At least some of these facets may be arranged, or angled, so as to redirect radiation 130 they receive from the second axial end 116 (i.e. from the front of the collector 134) preferentially back through the second axial end 116 of the generally tubular body 110. Such arrangements may result in specular reflection of the radiation 130 received from the second axial end 116 of the generally tubular body 110 to be preferentially directed back through the second axial end 116 of the generally tubular body 110.

In some embodiments, the structure 130 provided on the radially inner surface 128 of the generally tubular body 110 may comprise surface roughness. Such arrangements may result in diffuse reflection of the radiation 130 received from the second axial end 116 of the generally tubular body 110. In turn, this may reduce the amount of such radiation 130 that reaches the first axial end 114 of the generally tubular body 110 (and increases the amount which is directed back through the second axial end 116 of the generally tubular body 110).

In some embodiments, the structure 130 provided on the radially inner surface 128 of the generally tubular body 100 may comprise a diffraction grating.

It will be appreciated that the direction in which each diffraction order radiation is scattered by a diffraction grating is dependent on: an angle of incidence of the incident radiation 130; the wavelength of the incident radiation 130; and a pitch of the diffraction grating. It will be appreciated that diffraction efficiencies (i.e. how much of the incident radiation is scattered into each diffraction order) of a diffraction grating are dependent on a shape of a unit call of the diffraction grating.

The diffraction grating may be configured such that the diffraction efficiencies and the directions of the diffraction orders generated by radiation received from the second axial end 116 are such that the amount of radiation directed back out of the second axial end 116 is optimized or maximized.

In such embodiments, the structure 130 provided on the radially inner surface of the generally tubular body 110 may comprise features with dimensions that are of the same order of magnitude as a wavelength of the laser radiation. The wavelength of the laser radiation may generally be of the order of 1-10 µm. Specific examples of the wavelength of the laser radiation include: within 10% of 1 µm; within 10% of 2 µm; and within 10% of 10 µm.

In some embodiments, the apparatus 100, 200, 300 shown in Figures 3 to 6 may further comprise a gas source 144 (see Figure 6) operable to deliver gas to the inlet 124 of the fluid passageway 122 defined between the inner tubular portion 118 and the outer tubular portion 120. The gas delivered to the inlet 124 of the fluid passageway 122 may flow along the fluid passageway 122 from the inlet 124 (at the first axial end 114) to the outlet 126 proximate to the second axial end 116, where it may be directed radially outwards from the axis 112.

In some embodiments, the structure 130 provided on the radially inner surface 128 of the generally tubular body 110 may comprise features with dimensions that are significantly smaller than an inner diameter of the generally tubular body 110.

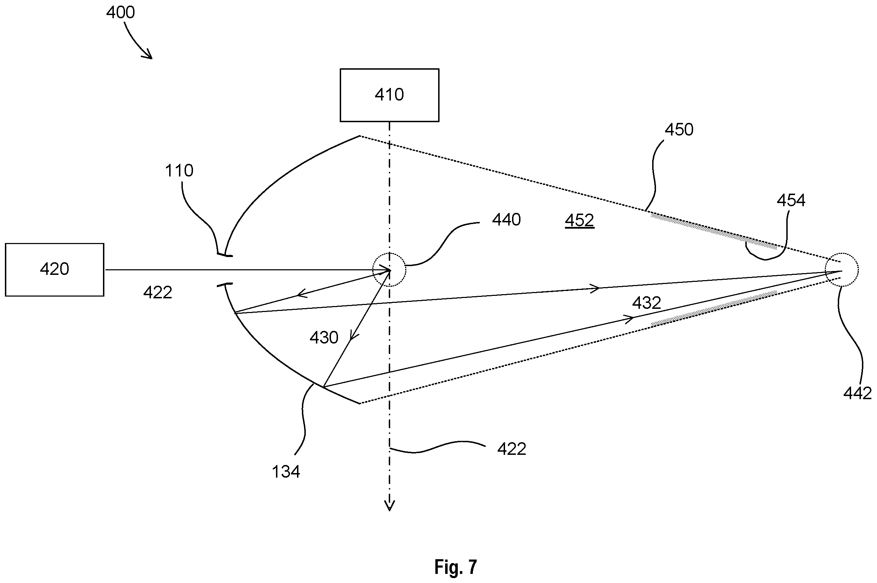

Some embodiments of the present disclosure relate to a laser-produced plasma radiation source comprising the apparatus 100, 200, 300 shown in one of Figures 3 to 6. An example of such a laser-produced plasma radiation source 400 is shown schematically in Figure 7.

The laser-produced plasma radiation source 400 comprises the apparatus 100, 200, 300 shown in one of Figures 3 to 6, which comprises a generally tubular body 110 and, optionally, a collector reflector 134. The laser-produced plasma radiation source 400 further comprises: a fuel target generator 410 and a laser system 420. The fuel target generator 410 is operable to generate a stream of fuel targets that propagate along a fuel trajectory 412. The laser system 420 operable to direct laser radiation through the generally tubular body 110 from the first axial end of the body to the second axial end of the body so as to intercept the fuel trajectory.

As explained above, the laser radiation 422 is incident on the fuel targets (for example a tin targets), which may cause the fuel target to at least partially form a plasma that emits radiation 430 (for example extreme ultraviolet, EUV, radiation). The interception of the laser radiation 422 and the fuel trajectory 412 may coincide with a first focal position 440 of the collector 134 of the laser-produced plasma source 400. The reflective surface 136 of the collector reflector 134 may be arranged to focus radiation 432 emitted by the plasma at a second focal position 442 of the collector 134.

The laser radiation 422 may comprise infrared radiation. The laser radiation 422 may have a wavelength of the order of 1-10 µm. Specific examples of the wavelength of the laser radiation include: within 10% of 1 µm ; within 10% of 2 µm; and within 10% of 10 µm.

In some embodiments, the structure 130 provided on the radially inner surface 128 of the generally tubular body 110 may comprise features with dimensions that are significantly larger than a wavelength of the laser radiation 422. Such embodiments may use such features to direct radiation 130 received from the second axial end 116 back towards the second axial end 116 via specular reflection.

In some embodiments, the structure 130 provided on the radially inner surface 128 of the generally tubular body 110 may comprise features with dimensions that are of the same order of magnitude as a wavelength of the laser radiation 124. Such embodiments may use such features to cause diffraction of radiation 130 received from the second axial end 116. The features may be configured such that such radiation diffracted by such features is preferentially directed back towards the second axial end 116.

In some embodiments, the laser-produced plasma radiation source 400 may further comprise a source vessel 450 arranged to at least partially define a volume 452 that is adjacent to the second axial end 116 of the generally tubular body 110.

In some embodiments, the source vessel 450 may comprise a vessel wall, at least a portion of which is provided with a laser light absorbing inside surface 454.

Some embodiments of the present disclosure relate to an exposure apparatus comprising the laser-produced plasma radiation source 400 shown in Figure 7 and as described above.

The exposure apparatus may comprise any apparatus for exposing an object to a dose of radiation. The exposure apparatus may comprise a lithographic apparatus (also known as a scanner), for example a lithographic apparatus LA of the type shown in Figure 1 above. Alternatively, the exposure apparatus may comprise a metrology apparatus, for example for measuring overlay. Alternatively, the exposure apparatus may comprise an inspection apparatus, for example an actinic mask inspection apparatus, for example an actinic mask inspection apparatus MS of the type shown in Figure 2.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical, and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

The following clauses are part of the present disclosure.
1. An apparatus for a laser-produced plasma radiation source, the apparatus comprising a generally tubular body defining an axis and extending from a first axial end to a second axial end;
   wherein the generally tubular body comprises an inner tubular portion and an outer tubular portion surrounding the inner tubular portion so as to define a volume therebetween, the volume defining a fluid passageway extending from an inlet at the first axial end to an outlet proximate to the second axial end;
   wherein the inner tubular portion and the outer tubular portion are arranged such that the outlet of the fluid passageway directs fluid received at the inlet generally radially outwards from the axis; and
   wherein a radially inner surface of the generally tubular body is provided with a structure configured such that radiation received by said radially inner surface from the second axial end is at least partially directed back through the second axial end of the generally tubular body.
2. The apparatus of clause 1 further comprising a collector generally surrounding the generally tubular body, the collector provided with a reflective surface facing a volume that is adjacent to the second axial end of the generally tubular body.
3. An apparatus for a laser-produced plasma radiation source, the apparatus comprising:
   a collector, the collector provided with a concave reflective surface with a central aperture; and
   a generally tubular body defining an axis and extending from a first axial end to a second axial end, which generally tubular body disposed in the central aperture of the collector, the concave reflective surface of the collector facing a volume that is adjacent to the second axial end of the generally tubular body;
   wherein a radially inner surface of the generally tubular body is provided with a structure configured such that radiation received by said radially inner surface from the second axial end is at least partially directed back through the second axial end of the generally tubular body.
4. The apparatus of clause 3 wherein the generally tubular body comprises an inner tubular portion and an outer tubular portion surrounding the inner tubular portion so as to define a volume therebetween, the volume defining a fluid passageway extending from an inlet at the first axial end to an outlet proximate to the second axial end; and wherein the inner tubular portion and the outer tubular portion are arranged such that the outlet of the fluid passageway directs fluid received at the inlet generally radially outwards from the axis.
5. The apparatus of any one of the preceding clauses wherein the structure provided on the radially inner surface of the generally tubular body is such that a greater portion of the radiation received by said radially inner surface from the second axial end is directed back through the second axial end of the generally tubular body than would be directed back through the second axial end of the generally tubular body by a smooth or flat radially inner surface of the generally tubular body.
6. The apparatus of any one of the preceding clauses wherein the structure provided on the radially inner surface of the generally tubular body is configured so as to maximize a portion of the radiation received by said radially inner surface from the second axial end that is directed back through the second axial end of the generally tubular body.
7. The apparatus of any one of the preceding clauses wherein the structure provided on the radially inner surface of the generally tubular body comprises a sawtooth profile in cross section in a plane parallel to the axis.
8. The apparatus of any one of the preceding clauses wherein the structure provided on the radially inner surface of the generally tubular body comprises a plurality of facets and wherein adjacent pairs of facets are disposed at different angles in a plane parallel to the axis.
9. The apparatus of any one of the preceding clauses wherein the structure provided on the radially inner surface of the generally tubular body comprises a plurality of generally frustoconical facets.
10. The apparatus of any one of the preceding clauses wherein the structure provided on the radially inner surface of the generally tubular body comprises surface roughness.
11. The apparatus of any one of the preceding clauses wherein the structure provided on the radially inner surface of the generally tubular body comprises a diffraction grating.
12. The apparatus of any one of the preceding clauses when dependent either directly on clause 1 or clause 4, the apparatus further comprising a gas source operable to deliver gas to the inlet of the fluid passageway defined between the inner tubular portion and the outer tubular portion.
13. The apparatus of any one of the preceding clauses wherein the structure provided on the radially inner surface of the generally tubular body comprises features with dimensions that are significantly smaller than an inner diameter of the generally tubular body.
14. A laser-produced plasma radiation source comprising:
   the apparatus of any one of the preceding clauses;
   a fuel target generator operable to generate a stream of fuel targets that propagate along a fuel trajectory; and
   a laser system operable to direct laser radiation through the generally tubular body from the first axial end of the body to the second axial end of the body so as to intercept the fuel trajectory.
15. The laser-produced plasma radiation source of clause 14 wherein the structure provided on the radially inner surface of the generally tubular body comprises features with dimensions that are significantly larger than a wavelength of the laser radiation.
16. The laser-produced plasma radiation source of clause 14 or clause 15 wherein the structure provided on the radially inner surface of the generally tubular body comprises features with dimensions that are of the same order of magnitude as a wavelength of the laser radiation.
17. The laser-produced plasma radiation source of any one of clauses 14 to 16 further comprising a source vessel arranged to at least partially define a volume that is adjacent to the second axial end of the generally tubular body.
18. The laser-produced plasma radiation source of clause 17 wherein the source vessel comprises a vessel wall, at least a portion of which is provided with a laser light absorbing inside surface.
19. An exposure apparatus comprising the laser-produced plasma radiation source of any one of clauses 14 to 18.
20. A method of generating plasma radiation comprising providing laser-produced plasma radiation source according to any one of clauses 14 to 18, said method comprising:
   - directing the stream of fuel targets along the fuel trajectory;
   - directing the laser radiation through the generally tubular body from the first axial end of the body to the second axial end of the body whereby intercepting the fuel trajectory, whereby at least part of the laser radiation is incident on at least one of the fuel targets thereby forming a plasma that emits plasma radiation; and
   - at least partially direct back, through the second axial end of the generally tubular body, radiation that is received by the radially inner surface from the second axial end with the structure configured thereon.
21. The method of clause 20, wherein the radiation that is at least partially directed back includes a portion of the laser radiation.
22. The method of clause 20, wherein the radiation that is at least partially directed back comprises stray light of the laser radiation.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An apparatus for a laser-produced plasma radiation source, the apparatus comprising a generally tubular body defining an axis and extending from a first axial end to a second axial end;
wherein the generally tubular body comprises an inner tubular portion and an outer tubular portion surrounding the inner tubular portion so as to define a volume therebetween, the volume defining a fluid passageway extending from an inlet at the first axial end to an outlet proximate to the second axial end;
wherein the inner tubular portion and the outer tubular portion are arranged such that the outlet of the fluid passageway directs fluid received at the inlet generally radially outwards from the axis; and
wherein a radially inner surface of the generally tubular body is provided with a structure configured such that radiation received by said radially inner surface from the second axial end is at least partially directed back through the second axial end of the generally tubular body.

2. The apparatus of claim 1 further comprising a collector generally surrounding the generally tubular body, the collector provided with a reflective surface facing a volume that is adjacent to the second axial end of the generally tubular body.

3. An apparatus for a laser-produced plasma radiation source, the apparatus comprising:
a collector, the collector provided with a concave reflective surface with a central aperture; and
a generally tubular body defining an axis and extending from a first axial end to a second axial end, which generally tubular body disposed in the central aperture of the collector, the concave reflective surface of the collector facing a volume that is adjacent to the second axial end of the generally tubular body;
wherein a radially inner surface of the generally tubular body is provided with a structure configured such that radiation received by said radially inner surface from the second axial end is at least partially directed back through the second axial end of the generally tubular body.

4. The apparatus of claim 3 wherein the generally tubular body comprises an inner tubular portion and an outer tubular portion surrounding the inner tubular portion so as to define a volume therebetween, the volume defining a fluid passageway extending from an inlet at the first axial end to an outlet proximate to the second axial end; and wherein the inner tubular portion and the outer tubular portion are arranged such that the outlet of the fluid passageway directs fluid received at the inlet generally radially outwards from the axis.

5. The apparatus of any preceding claim wherein the structure provided on the radially inner surface of the generally tubular body is such that a greater portion of the radiation received by said radially inner surface from the second axial end is directed back through the second axial end of the generally tubular body than would be directed back through the second axial end of the generally tubular body by a smooth or flat radially inner surface of the generally tubular body.

6. The apparatus of any preceding claim wherein the structure provided on the radially inner surface of the generally tubular body is configured so as to maximize a portion of the radiation received by said radially inner surface from the second axial end that is directed back through the second axial end of the generally tubular body.

7. The apparatus of any preceding claim wherein the structure provided on the radially inner surface of the generally tubular body comprises a sawtooth profile in cross section in a plane parallel to the axis.

8. The apparatus of any preceding claim wherein the structure provided on the radially inner surface of the generally tubular body comprises a plurality of facets and wherein adj acent pairs of facets are disposed at different angles in a plane parallel to the axis.

9. The apparatus of any preceding claim wherein the structure provided on the radially inner surface of the generally tubular body comprises a plurality of generally frustoconical facets.

10. The apparatus of any preceding claim wherein the structure provided on the radially inner surface of the generally tubular body comprises surface roughness.

11. The apparatus of any preceding claim wherein the structure provided on the radially inner surface of the generally tubular body comprises a diffraction grating.

12. The apparatus of any preceding claim wherein the structure provided on the radially inner surface of the generally tubular body comprises features with dimensions that are significantly smaller than an inner diameter of the generally tubular body.

13. A laser-produced plasma radiation source comprising:
the apparatus of any preceding claim;
a fuel target generator operable to generate a stream of fuel targets that propagate along a fuel trajectory; and
a laser system operable to direct laser radiation through the generally tubular body from the first axial end of the body to the second axial end of the body so as to intercept the fuel trajectory.

14. The laser-produced plasma radiation source of claim 13 wherein the structure provided on the radially inner surface of the generally tubular body comprises features with dimensions that are significantly larger than a wavelength of the laser radiation and/or
wherein the structure provided on the radially inner surface of the generally tubular body comprises features with dimensions that are of the same order of magnitude as a wavelength of the laser radiation.

15. The laser-produced plasma radiation source of any one of claims 13 to 14 further comprising a source vessel arranged to at least partially define a volume that is adjacent to the second axial end of the generally tubular body wherein the source vessel comprises a vessel wall, wherein at least a portion of the vessel wall is provided with a laser light absorbing inside surface.
